# EUROPEAN PATENT APPLICATION

(11) **EP 4 531 504 A1**
(43) Date of publication of application: **02.04.2025**
(21) Application number: 24197056.5
(22) Date of filing: 28.08.2024
(51) Int. Cl.: H05K 3/46, H05K 1/02, H05K 3/00

(54) **STRESS MITIGATION ARCHITECTURES FOR GLASS CORE SUBSTRATES**

(30) Priority: 28.09.2023 US 202318374609
(71) Applicant: Intel Corporation, Santa Clara, CA 95054 (US)
(72) Inventor: BHURE, Rahul, Mesa, 85209 (US); PAGE, Mitchell, Mesa, 85206 (US); PEOPLES, Joseph, Gilbert, 85296 (US); KONG, Jieying, Chandler, 85286 (US); HAEHN, Nicholas S., Scottsdale, 85251 (US); TRIPATHI, Astitva, Mesa, 85212 (US); ANGOUA, Bainye Francoise, Chandler, 85226 (US); KORNBLUTH, Yosef, Phoenix, 85014 (US); ROSALES-YEOMANS, Daniel, Gilbert, 85297 (US); STACEY, Joshua, Chandler, 85226 (US); CANDADAI, Aaditya Anand, Chandler, 85226 (US); LI, Yonggang Yong, Chandler, 85248 (US); NDUKUM, Tchefor, Chandler, 85286 (US); COATNEY, Scott, Chandler, 85225 (US); DUAN, Gang, Chandler, 85248 (US); JONES, Jesse, Chandler, 85248 (US); PIETAMBARAM, Srinivas Venkata Ramanuja, Chandler, 85249 (US); SENEVIRATNE, Dilan, Phoenix, 85048 (US); ANDERSON, Matthew, Chandler, 85249 (US)
(74) Representative: 2SPL Patentanwälte PartG mbB

(57) **Abstract**

Embodiments disclosed herein include package substrates with a glass core. In an embodiment, an apparatus comprises a core with a first width, and the core comprises a glass layer. In an embodiment, a via is provided through a thickness of the core, where the via is electrically conductive. In an embodiment, a first layer is provided over the core, where the first layer comprises a second width that is smaller than the first width. In an embodiment, a second layer is provided under the core, where the second layer comprises a third width that is smaller than the first width.

## Description

### BACKGROUND

As semiconductor packaging architectures continue towards more complex and more compact systems, new material solutions may be used to enable such architectures. One promising candidate for use in packaging substrates is a glass core layer. In such substrates, a glass core is sandwiched between overlying and underlying buildup layers. Electrically conductive vias are provided through the glass core in order to provide electrical coupling between the overlying and underlying buildup layers. Glass cores are beneficial because they can provide high density vias. Glass is also a high modulus material, which provides desirable stiffness to the overall package substrate. Glass cores can also improve planarity issues at the panel level.

However, glass cores are not without issue. For example, compressive stress vectors applied to the glass core by the overlying buildup layers can result in catastrophic defects, especially at the panel level. One leading defect mechanism is sometimes referred to as a seware defect mechanism. When a seware defect occurs, the forces applied to the panel result in a horizontal splitting of the glass core. That is, the panel is split into a top side (comprising the top buildup layers and a top half of the glass core) and a bottom side (comprising the bottom buildup layers and a bottom half of the glass core). The top side and the bottom side warp in opposite directions of each other.

### BRIEF DESCRIPTION OF THE DRAWINGS

Figure 1A is a plan view illustration of a panel with a plurality of package substrate units distributed across the panel, in accordance with an embodiment.
Figure 1B is a plan view illustration of a panel with a plurality of package substrate units with a trench through the buildup layers around the quarter panel regions, in accordance with an embodiment.
Figure 1C is a plan view illustration of a panel with a plurality of package substrate units with a trench and a firewall provided around the quarter panel regions, in accordance with an embodiment.
Figure 2A is a cross-sectional illustration of a portion of a panel that illustrates a trench through the buildup layers along the saw street, in accordance with an embodiment.
Figure 2B is a cross-sectional illustration of a portion of a package substrate after singulation that shows the edge of the buildup layers being offset from the edge of the glass core, in accordance with an embodiment.
Figure 2C is a cross-sectional illustration of a portion of a panel that illustrates a first trench along a saw street and a second trench inside the first trench, in accordance with an embodiment.
Figure 2D is a cross-sectional illustration of a portion of a package substrate after singulation that shows an edge of the buildup layers set back from an edge of the glass core and the second trench, in accordance with an embodiment.
Figure 2E is a cross-sectional illustration of a portion of a panel that illustrates a trench along the saw street with sloped sidewalls, in accordance with an embodiment.
Figure 2F is a cross-sectional illustration of a portion of a package substrate after singulation that shows an edge of the buildup layers that is offset from an edge of the glass core, in accordance with an embodiment.
Figure 3 is a cross-sectional illustration of a package substrate with a glass core and buildup layers with edges that are set back from the edges of the glass core, in accordance with an embodiment.
Figure 4A is a cross-sectional illustration of a portion of a package substrate with a glass core that includes a first region with defects at an edge of the glass core and a second region that is substantially free from defects, in accordance with an embodiment.
Figure 4B is a cross-sectional illustration of a portion of a package substrate with a glass core and buildup layers with a trench that is used to reduce the spread of defects from an edge of the glass core, in accordance with an embodiment.
Figure 5A is a plan view illustration of a package substrate with a trench through the buildup layers that is set in from an edge of the package substrate, in accordance with an embodiment.
Figure 5B is a cross-sectional illustration of the package substrate in Figure 5A along line 5-5', in accordance with an embodiment.
Figure 5C is a cross-sectional illustration of a package substrate with a trench that includes tapered sidewalls, in accordance with an embodiment.
Figure 6A is a plan view illustration of a package substrate with a trench that includes a liner along an outer sidewall of the trench, in accordance with an embodiment.
Figure 6B is a cross-sectional illustration of the package substrate in Figure 6A along line 6-6', in accordance with an embodiment.
Figure 6C is a cross-sectional illustration of an edge of the package substrate showing the compressive force applied to the edge of the glass core by the trench with a liner, in accordance with an embodiment.
Figure 7A is a cross-sectional illustration of a portion of a panel with an insert in the glass core across a saw street, in accordance with an embodiment.
Figure 7B is a cross-sectional illustration of a portion of a package substrate with an insert at the edge of the glass core, in accordance with an embodiment.
Figure 7C is a cross-sectional illustration of a portion of a package substrate with an insert that is triangular at the edge of the glass core, in accordance with an embodiment.
Figure 7D is a cross-sectional illustration of a portion of a package substrate with an insert into the glass core that is set away from an edge of the glass core, in accordance with an embodiment.
Figure 8 is a cross-sectional illustration of a package substrate with buildup layers that include edge surfaces with protrusions, in accordance with an embodiment.
Figures 9A - 9G are cross-sectional illustrations depicting a process for forming a package substrate with a glass core and recessed buildup layers that have edge protrusions, in accordance with an embodiment.
Figures 10A - 10C are cross-sectional illustrations depicting a process for forming a package substrate with a glass core and recessed buildup layers that have edge protrusions, in accordance with an additional embodiment.
Figure 11 is a cross-sectional illustration of a package substrate with a glass core that includes an embedded stress reduction layer, in accordance with an embodiment.
Figure 12 is a cross-sectional illustration of a portion of a package substrate with an insert that passes through a thickness of the glass core in order to provide a compressive force on the glass core, in accordance with an embodiment.
Figure 13A is a plan view illustration of a portion of a panel that includes columns of inserts through the glass core adjacent to a saw street, in accordance with an embodiment.
Figure 13B is a plan view illustration of a portion of a panel that includes a pair of insert columns through the glass core adjacent to a saw street, in accordance with an embodiment.
Figure 13C is a plan view illustration of a portion of a panel that includes a ring of inserts around a glass core unit, in accordance with an embodiment.
Figures 14A - 14G are cross-sectional illustrations of a portion of a panel showing a process for forming compressive inserts through a thickness of the glass core, in accordance with an embodiment.
Figure 15 is a schematic of a computing device built in accordance with an embodiment.

### EMBODIMENTS OF THE PRESENT DISCLOSURE

Described herein are electronic systems, and more particularly, package substrates with glass cores that include stress mitigation architectures, in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

As noted above, panel level manufacturing of package substrates with glass cores can result in significant defects that can bring yields down to zero. Particularly, stress induced into the glass core from the overlying buildup layers has been shown to be a significant contributing factor to seware defect generation at the panel level. The stress is generated, at least in part, due to a coefficient of thermal expansion (CTE) mismatch between the material of the glass core and the material of the buildup layers. Accordingly, embodiments disclosed herein provide architectures, processes, and other solutions that allow for stress mitigation at the panel level and also at the individual unit level.

Some embodiments include the use of trenches through the thickness of the buildup layers. For example, the trenches may be provided at the saw street locations between the individual units. The singulation process may then pass through the glass core only. In such instances, the resulting package substrate units may have buildup layers with edge surfaces that are set back from the edge surface of the glass core. Trenches may also be used as a "firewall" type structure. The firewall trench is set further in from the edge of the glass core than the first trench along the saw street. The firewall trench mitigates the propagation of cracks and other defects from the edge of the glass core further into the center of the glass core.

Other embodiments may include stress relief trenches that are set in from the edge of the buildup layers. The stress relief trenches may also include a liner along the outer sidewall. Due to CTE mismatch between the liner and the buildup material, a controlled warpage can be generated. This controlled warpage can induce a compressive force on the glass core in order to mitigate defect propagation.

In yet another embodiment, inserts can be provided along the edges of the glass core. The inserts may have a CTE that is similar to the CTE of the glass, while also having a higher modulus than the glass. This allows for stress to be preferentially absorbed by the insert, which can prevent or minimize damage to the glass core.

In yet another embodiment, compressive pins can be provided through a thickness of the glass core. The pins may have a top pad and a bottom pad. Upon curing the pin, the top pad is drawn toward the bottom pad in order to induce a compressive force on the glass core. Such pins can be arranged in a ring (or multiple rings) around a perimeter of the glass core in each package substrate.

In embodiments disclosed herein, trenches through the buildup layers can be provided by one or more different processing operations. In one process, laser ablation is used to remove the buildup layer material and expose the underlying glass core. In another process, dummy structures (e.g., dummy copper) can be fabricated along with the fabrication of the buildup layers. The dummy structures can then be removed with an etching process in order to expose the underlying glass core. In such an embodiment, the outer edge of the buildup layers may have a unique profile, including a profile that includes a protrusion.

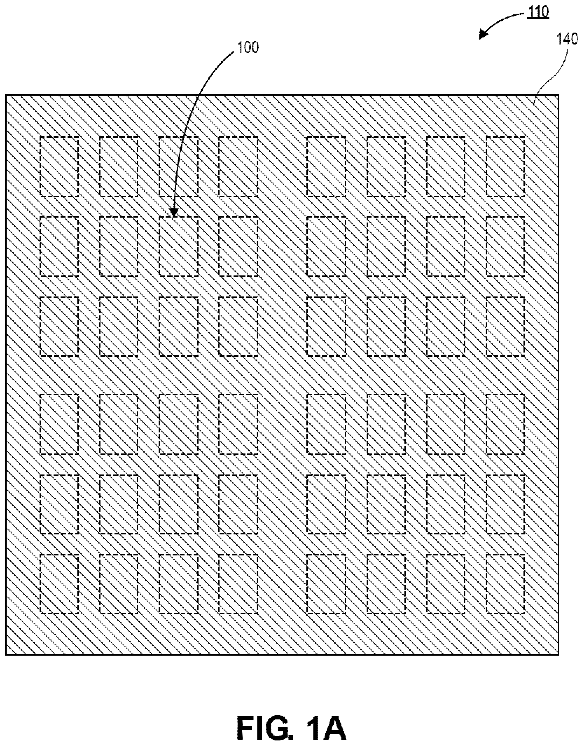

Referring now to Figure 1A, a plan view illustration of a panel 110 is shown, in accordance with an embodiment. The panel 110 may include a plurality of package substrate units 100 that are distributed across the panel 110. The individual units 100 may be provided in a grid-like array. For example, the units 100 may be provided in an array that forms four quarter panels, and each quarter panel has twelve individual units 100. Though, the number and layout of the units 100 within the panel 110 may be varied depending on the size of the panel 110 and the size of the units 100, among other factors. The use of panel level processing allows for improved throughput. That is, a plurality of units 100 may be fabricated and assembled substantially in parallel with each other. After the panel 110 is completed, individual units 100 may be singulated with any suitable process. For example, a saw or other mechanical tool may cut along saw streets between the individual units 100, as will be described in greater detail below.

In the illustrated embodiment, the units 100 are shown with dashed lines. Dashed lines are used since, at the panel 110 level, the individual units 100 may not have any distinguishable boundary from each other. For example, the top layer (e.g., buildup layers 140) may be a substantially uniform top surface. In some instances voided regions of the panel 110 (e.g., regions without electrical routing) may be provided along the saw streets between the units 100.

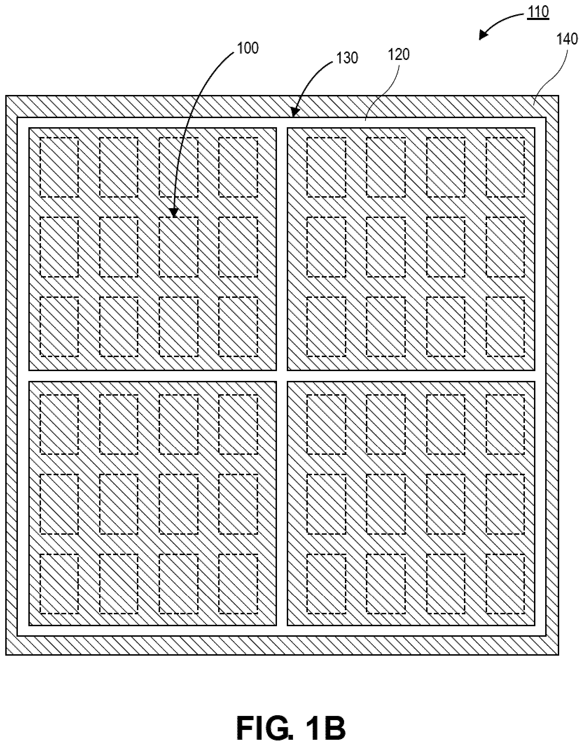

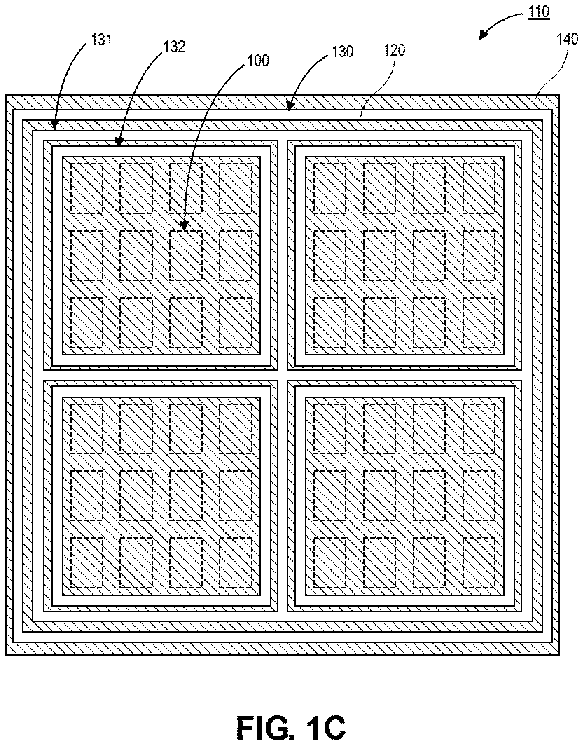

The panel 110 may comprise a glass core (not shown). Buildup layers 140 may be provided above and/or below the glass core. As described above, the interaction between the buildup layers 140 and the glass core may result in significant warpage or other damage (e.g., seware defects). Accordingly, embodiments, such as those shown in Figures 1B and 1C may be used in order to mitigate defects.

Referring now to Figure 1B, a plan view illustration of a panel 110 is shown, in accordance with an additional embodiment. In an embodiment, the panel 110 may include a trench 130 that passes through the buildup layers 140. The trench 130 may expose a surface of the underling glass core 120. In an embodiment, the trench 130 may be formed with a laser ablation process. For example, a laser source may be used in order to selectively remove the dielectric material of the buildup layers 140. Though, other material removal processes may also be used.

The trench 130 may be provided around a perimeter of the units 100. For example, the trench 130 may be a ring that is offset from an edge of the panel 110. Though, the trench 130 may also extend all the way to the edge of the panel 110 in other embodiments. The trench 130 may have a width that is approximately 10µm or larger, or up to approximately 250µm. Though, trenches 130 may have smaller or larger widths in some embodiments.

In an embodiment, the trench 130 may also include portions that follow saw streets between quarter panel regions of the panel 110. For example, the trench 130 in Figure 1B has a cross shape that defines four quadrants of the panel 110. While not shown, some embodiments may also include a trench 130 that surrounds each of the individual units 100.

Referring now to Figure 1C, a plan view illustration of a panel 110 is shown, in accordance with yet another embodiment. In the embodiment shown in Figure 1C, a plurality of trenches 130, 131, and 132 are provided. The multiple trenches 130, 131, and 132 may further reduce the stress induced on the glass core 120. In some embodiments, the trench 130 may be a ring provided proximate to a perimeter of the panel 110. The second trench 131 may be a ring around the quarter panels. The trench 131 may also have a cross along the saw streets between the quarter panel regions. In an embodiment, the third trenches 132 may be rings within the second trench 131 and around the units 100 in a quarter panel.

In an embodiment, the second trench 131 may be along saw streets of the panel 110. However, the third trenches 132 may be within the saw streets that define each quarter panel. That is, the entirety of the third trenches 132 may persist after a singulation process. In some embodiments, the third trenches 132 may be referred to as a firewall trench 132. The third trench 132 may help reduce the spread or propagation of defects from the outer edges of the glass core 120 further into a center of the glass core 120. As such, electrical routing features (e.g., vias, etc.) can be protected, and the possibility of seware damage is mitigated. In some embodiments, firewall type trenches 132 may also be provided at the unit 100 level.

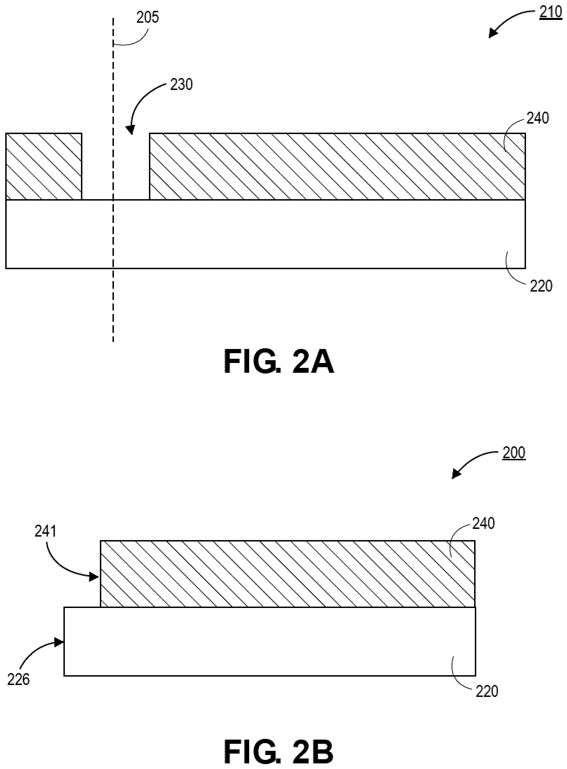

Referring now to Figures 2A - 2F, cross-sectional illustrations of panels 210 and individual package substrates 200 are shown, in accordance with various embodiments. In the embodiments shown, a glass core 220 is provided below buildup layers 240. It is to be appreciated that similar buildup layer 240 structures can be provided on the bottom surface of the glass core 220 as well.

In an embodiment, the glass core 220 may be substantially all glass. The glass core 220 may be a solid mass comprising a glass material with an amorphous crystal structure where the solid glass core may also include various structures - such as vias, cavities, channels, or other features - that are filled with one or more other materials (e.g., metals, metal alloys, dielectric materials, etc.). As such, the glass core 220 may be distinguished from, for example, the "prepreg" or "RF4" core of a Printed Circuit Board (PCB) substrate which typically comprises glass fibers embedded in a resinous organic material such as an epoxy. More particularly, the glass core 220 may be any suitable glass formulation that has the necessary mechanical robustness and compatibility with semiconductor packaging manufacturing and assembly processes. For example, the glass core 220 may comprise aluminosilicate glass, borosilicate glass, alumino-borosilicate glass, silica, fused silica, or the like. In some embodiments, the glass core 220 may include one or more additives, such as, but not limited to, Al₂O₃, B₂O₃, MgO, CaO, SrO, BaO, SnO₂, Na₂O, K₂O, SrO, P₂O₃, ZrO₂, Li₂O, Ti, and Zn. More generally, the glass core 220 may comprise silicon and oxygen, as well as any one or more of aluminum, boron, magnesium, calcium, barium, tin, sodium, potassium, strontium, phosphorus, zirconium, lithium, titanium, and zinc. In an embodiment, the glass core 220 may comprise at least 23 percent silicon (by weight) and at least 26 percent oxygen (by weight). In some embodiments, the glass core 220 may further comprise at least 5 percent aluminum (by weight).

In an embodiment, the glass core 220 may have a thickness (between a top and bottom surface) that is between approximately 50µm and approximately 2,000µm. Though, thinner or thicker glass cores 220 may be used in other embodiments. The glass core 220 may have a substantially rectangular shape (when viewed from above in a plan view). Though, other shapes may also be used for the glass core 220.

In an embodiment, the buildup layers 240 may comprise organic buildup film or any other dielectric material suitable for electrical packaging. The buildup layers 240 may comprise one or more laminated layers in order to form a structure with a desired thickness. In an embodiment, the buildup layers 240 may comprise electrically conductive features (e.g., pads, traces, vias, etc.) that are fabricated in conjunction with the formation of the buildup layers 240.

Embodiments disclosed herein may refer to two or more separate surfaces as being substantially coplanar with each other. As used herein, "substantially coplanar" may refer to two or more surfaces that are coplanar to within any manufacturing tolerance of a tool used to generate the surfaces. For example, in a singulation process, a saw may be used to cut through multiple layers of material. Since a single saw with a single sawing path is used to cut through the multiple layers, the exposed edges of those layers will be substantially coplanar. Substantially coplanar may also refer to two surfaces that are parallel to each other but on planes spaced apart from each other by approximately 3 µm or less. Substantially coplanar may also refer to two surfaces that contact each other and are within approximately 3° of being coplanar with each other. As used herein, "approximately" may refer to a range of values within ten percent of the stated value. For example, approximately 100µm may refer to a range between 90µm and 110µm.

Referring now to Figure 2A, a cross-sectional illustration of a portion of a panel 210 is shown, in accordance with an embodiment. In an embodiment, the buildup layer 240 over the glass core 220 includes a trench 230. The trench 230 may be coincident with a saw street 205 that passes through the panel 210. The saw street 205 may be a saw street 205 used to singulate a quarter panel region of the panel 210. In other embodiments, the saw street 205 may be provided between adjacent units. The trench 230 may be a ring that surrounds an entire panel 210, a quarter panel region, or an individual unit.

In an embodiment, the trenches 230 may have substantially vertical sidewalls. Though, embodiments may have trenches 230 with any sidewall profile. The trench 230 may have a width that is between approximately and approximately 250µm. Though, narrower or wider trenches 230 may also be used in some embodiments.

Referring now to Figure 2B, a cross-sectional illustration of a package substrate unit 200 is shown, in accordance with an embodiment. In an embodiment, the unit 200 shown in Figure 2B is from the panel 210 in Figure 2A after singulation along the saw street 205. In the illustrated embodiment, only a single edge of the unit 200 is shown for simplicity. It is to be appreciated that all edges of the unit 200 may be similar in shape and layout to the left edge shown in Figure 2B.

As shown, the edge 241 of the buildup layers 240 is set back from the edge 226 of the glass core 220. For example, the distance between the edge 241 and the edge 226 may be between approximately and approximately 250µm. Though, larger or smaller set back distances may also be used. Due to the set back of the edge 241, a portion of the top surface of the glass core 220 is exposed. Pulling back a portion of the buildup layers 240 from the edge of the glass core 220 also reduces the amount of stress that is induced into the glass core 220. Accordingly, defects at the edge 226 of the glass core 220 are less likely to propagate into a center of the glass core 220.

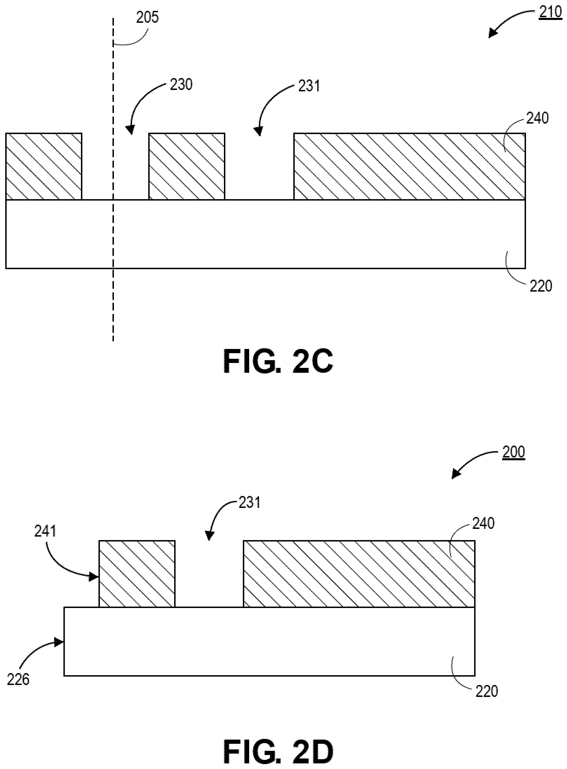

Referring now to Figure 2C, a cross-sectional illustration of a portion of a panel 210 is shown, in accordance with an embodiment. In an embodiment, the panel 210 may include buildup layers 240 that are provided over a glass core 220. In an embodiment, the panel 210 may include a first trench 230 that is provided along a saw street 205. The saw street 205 may be provided around a perimeter of the panel 210, between quarter panel regions of the panel 210, or between individual units 200 of the panel 210.

In an embodiment, a second trench 231 may be provided inside the first trench 230. The first trench 230 and the second trench 231 may be concentric rings with each other. A spacing between the first trench 230 and the second trench 231 may be between approximately 5µm and approximately 200µm in some embodiments. The trenches 230 and 231 may have similar widths. Though, in other embodiments, the widths of the trenches 230 and 231 may be different. The second trench 231 may be referred to as a firewall trench since it can be used to mitigate propagation of defects into the center of the glass core 220.

Referring now to Figure 2D, a cross-sectional illustration of a package substrate unit 200 is shown, in accordance with an embodiment. In an embodiment, the unit 200 is the result of singulation of the panel 210 shown in Figure 2C. As shown, the first trench 230 results in the edge 241 of the buildup layers 240 being set back from the edge 226 of the glass core 220. The second trench 231 results in an island of the buildup layer 240 being provided proximate to the edge of the unit 200. The island of the buildup layer 240 may be a ring that is set in from the edge 226 of the glass core 200.

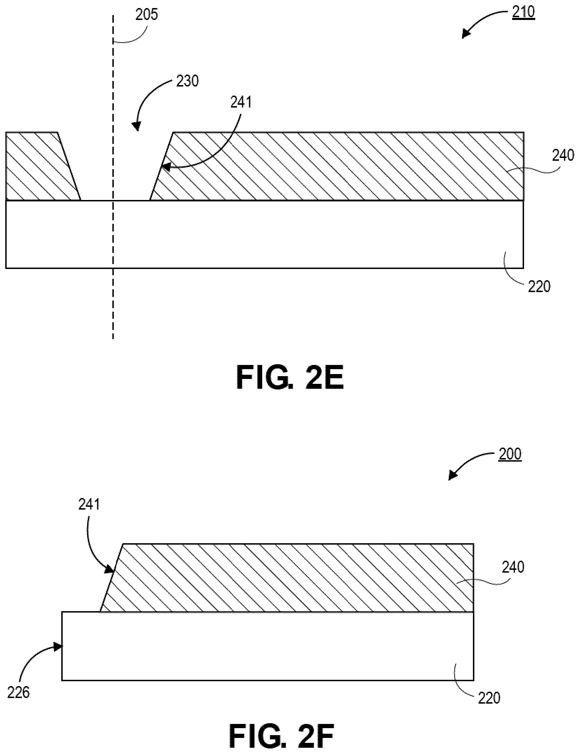

Referring now to Figure 2E, a cross-sectional illustration of a panel 210 is shown, in accordance with yet another embodiment. The panel 210 may include buildup layers 240 that are provided over a glass core 220. In an embodiment, a trench 230 through the buildup layers 240 exposes a top surface of the glass core 220. The trench 230 may be positioned along a saw street 205 of the panel 210. The saw street 205 may be around a perimeter of the panel 210, along quarter panel regions of the panel 210, or around units 200 of the panel 210.

In an embodiment, the trench 230 may have sidewalls 241. The sidewalls 241 may have a sloped or otherwise tapered profile. For example, a top surface of the buildup layers 240 may be narrower than a bottom surface of the buildup layers 240. Stated another way, the top of the trench 230 may be wider than the bottom of the trench 230. The slope of the sidewalls 241 may be dependent on various processing conditions, such as, but not limited to, laser power parameters, scanning speed, and the like.

Referring now to Figure 2F, a cross-sectional illustration of a package substrate unit 200 is shown, in accordance with an embodiment. The unit 200 in Figure 2F may be the result of a singulation process along the saw street 205 in Figure 2E. As illustrated, the edge 241 of the buildup layers 240 is offset from the edge 226 of the glass core 220. Accordingly, a portion of the top surface of the glass core 220 is exposed outside of the buildup layers 240.

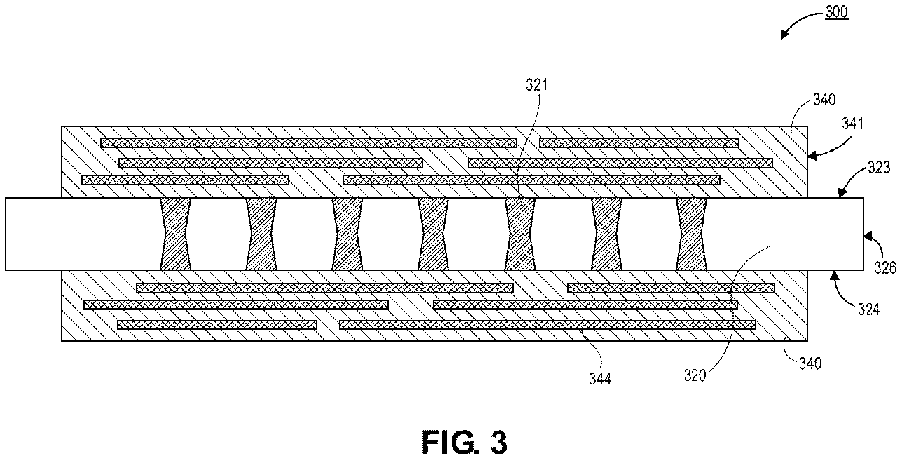

Referring now to Figure 3, a cross-sectional illustration of a package substrate unit 300 is shown, in accordance with an embodiment. In an embodiment, the unit 300 may include a glass core 320. The glass core 320 may be similar to any of the glass cores described in greater detail herein. In an embodiment, the glass core 320 may include sidewalls (or edges) 326 that couple a top surface 323 to a bottom surface 324. The edges 326 may be substantially vertical. That is, the edges 326 may be substantially orthogonal to the top surface 323 in some instances. Though, depending on the method of singulation, the edges 326 may have non-vertical profiles.

The glass core 320 may also include electrically conductive vias 321 that pass through a thickness of the glass core 320. The vias 321 may be lined with a liner (not shown) in some embodiments. The vias 321 may have any shaped cross-section, depending on the method of fabrication. For example, the vias 321 in Figure 3 have an hourglass shaped cross-section that is typical of double sided laser assisted etching processes. The vias 321 may comprise copper, aluminum, silver, alloys of metallic materials, or the like. In some embodiments, the vias 321 may include seed layers, barrier layers, and the like.

In an embodiment, the unit 300 may further comprise buildup layers 340 provided above and/or below the glass core 320. The buildup layers 340 may include organic dielectric material, such as laminated buildup film layers. Electrically conductive features 344 (e.g., pads, traces, vias, etc.) may also be embedded within the buildup layers 340. In an embodiment, the buildup layers 340 may have sidewalls (or edges) 341. The edges 341 may be vertical (e.g., substantially orthogonal to the top surface 323 of the glass core 320). In other embodiments, the edges 341 may be sloped, similar to embodiments described in greater detail above.

The unit 300 may have buildup layers 340 with a first width and the glass core 320 may have a second width that is larger than the first width. As such, the sidewalls 341 of the buildup layers 340 are set back from the edge 326 of the glass core 320. This exposes portions of the top surface 323 and the bottom surface 324. In an embodiment, the exposure of the top surface 323 and the bottom surface 324 aids in the reduction of the stress induced into the glass core 320.

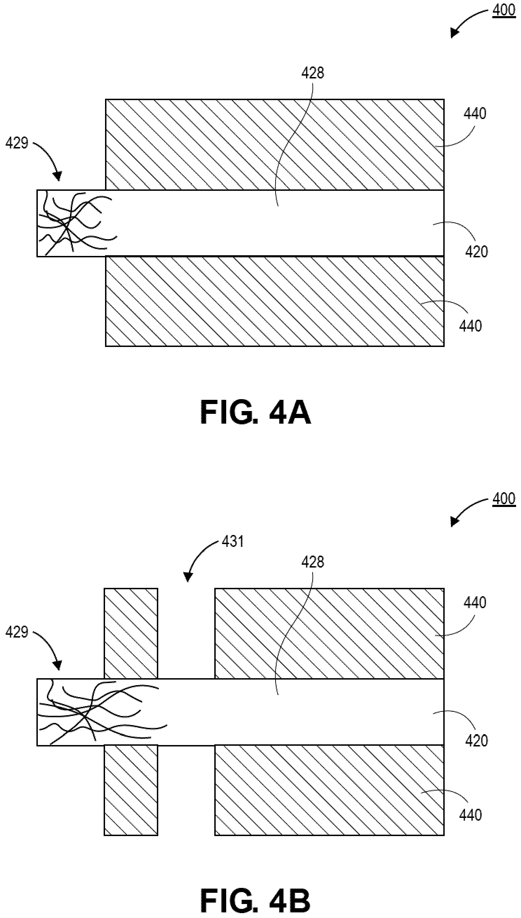

Referring now to Figure 4A, a cross-sectional illustration of a portion of a package substrate unit 400 is shown, in accordance with an embodiment. The unit 400 may include a glass core 420 with buildup layers 440 over and/or under the glass core 420. As shown, the glass core 420 may extend out beyond edges of the buildup layers 440. The exposed end regions of the glass core 420 allows for defect propagation reduction. For example, the glass core 420 may have a first region 429 around an outer edge of the unit 400 and a second region 428 at a center of the unit 400.

The first region 429 may have a relatively high defect density. The defects may include cracks, micro cracks, or the like. The defects may be generated due to the singulation process used to cut through the glass core 420. However, since the buildup layers 440 are set back, the stress on the first region 429 is reduced. This limits how far into the glass core 420 the defects are propagated. In some instances, the second region 428 may have a low defect density compared to the first region 429. For example, a defect density of the first region 429 may be approximately twice (or more) than the defect density of the second region 428. In some instances, the second region 428 may have up to 10% of the defects of the first region 429, up to 5% of the defects of the first region 429, or up to 1% of the defects of the first region 429. In an embodiment, a width of the first region 429 may be up to approximately 10µm, up to approximately 50µm, up to approximately 100µm, or up to approximately 250µm.

Referring now to Figure 4B, a cross-sectional illustration of a package substrate unit 400 is shown, in accordance with an additional embodiment. In an embodiment, the unit 400 in Figure 4B may be similar to the unit 400 in Figure 4A with the exception of a trench 431 in the unit 400 of Figure 4B. In an embodiment, the trench 431 may further mitigate the propagation of the defects into the center of the glass core 420. In some embodiments, the first region 429 may extend up to the trench 431. For example, the inner edge of the first region 429 may be outside of the inner sidewall of the trench 431. Though, in some instances the first region 429 may extend past the trench 431.

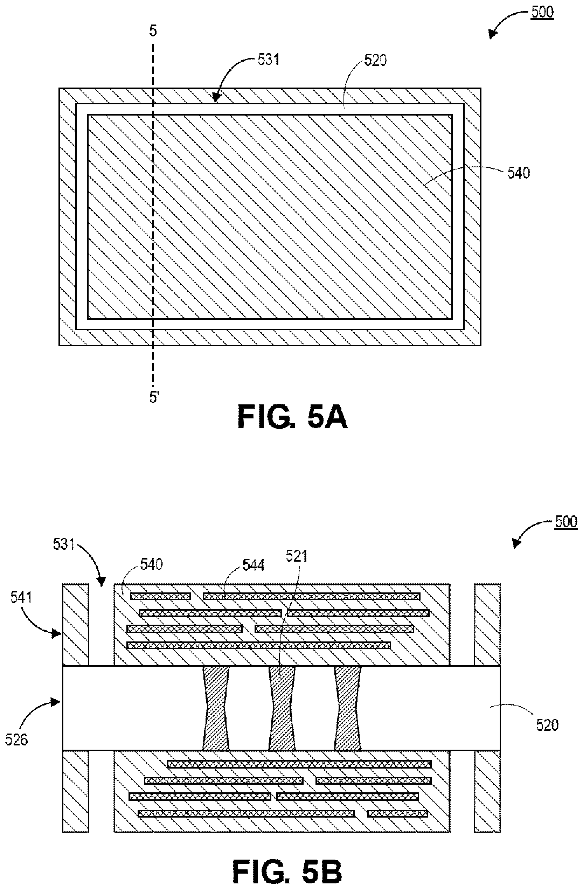

Referring now to Figure 5A, a plan view illustration of a package substrate unit 500 is shown, in accordance with an embodiment. In an embodiment, the unit 500 may comprise a stack including a glass core 520 with buildup layers 540 above and/or below the glass core 520. In an embodiment, the buildup layers 540 extend to the edges of the glass core 520. As shown in Figure 5A, a trench 531 is provided proximate to an edge of the unit 500. The trench 531 may be a ring, such as a rectangular ring. The trench 531 may be used as a stress relief feature in order to prevent or limit the transfer of stress from the buildup layers 540 into the glass core 520. The trench 531 passes through an entire thickness of the buildup layers 540 in order to expose a surface of the glass core 520.

Referring now to Figure 5B, a cross-sectional illustration of the package substrate unit 500 in Figure 5A along line 5-5' is shown, in accordance with an embodiment. In an embodiment, the glass core 520 may comprise electrically conductive vias 521 that pass through a thickness of the glass core 520. The vias 521 may have any shape (e.g., tapered sidewalls, vertical sidewalls, etc.). In some instances, a liner (not shown) may be provided between the vias 521 and the glass core 520.

Buildup layers 540 may be provided above and below the glass core 520. The buildup layers 540 may extend to the edge of the glass core 520. That is, instead of having a setback, an edge 541 of the buildup layers 540 may be substantially coplanar with an edge 526 of the glass core 520. For example, a singulation process used to form the unit 500 may include passing a saw blade through the buildup layers 540 and the glass core 520. The buildup layers 540 may include electrically conductive features 544 (e.g., pads, traces, vias, etc.). The electrically conductive features 544 may be fabricated during the assembly of the buildup layers 540 using traditional packaging assembly processes.

In an embodiment, trenches 531 pass through the buildup layers 540 to expose portions of the top surface and bottom surface of the glass core 520. In an embodiment, the trenches 531 may be set in from an edge 526 of the glass core 520. For example, the outer wall of the trenches 531 may be up to 250µm from the edge 526 of the glass core 520. In some instances, the outer wall of the trenches 531 may be between and 100µm from the edge 526 of the glass core 520. The walls of the trenches 531 may be substantially vertical in some embodiments. That is, the walls of the trenches 531 may be substantially orthogonal to the top surface of the glass core 520. In an embodiment, the region of the buildup layers 540 outside of the trenches 531 may be voided regions. That is, there may be no electrically conductive features 544 outside of the trenches 531.

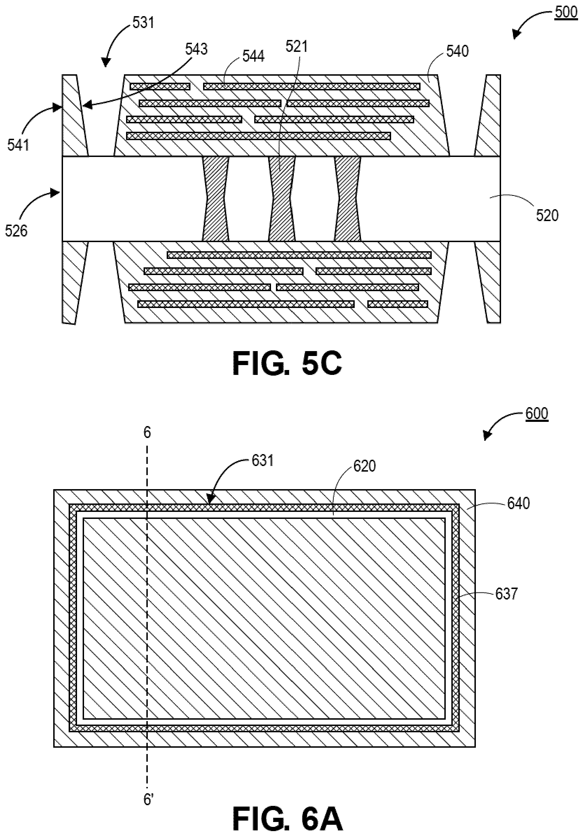

Referring now to Figure 5C, a cross-sectional illustration of a package substrate unit 500 is shown, in accordance with an additional embodiment. In an embodiment, the unit 500 in Figure 5C is substantially similar to the unit 500 in Figure 5B, with the exception of the structure of the trenches 531. Instead of having vertical sidewalls, the trenches 531 may have sidewalls 543 that are sloped or tapered. The sloped sidewalls 543 may be the result of a laser ablation process used to form the trenches 531. In an embodiment, a top of the trench 531 may be wider than a bottom of the trench 531.

Referring now to Figure 6A, a plan view illustration of a package substrate unit 600 is shown, in accordance with an embodiment. In an embodiment, the unit 600 may comprise a stack including a glass core 620 with buildup layers 640 above and/or below the glass core 620. In an embodiment, the buildup layers 640 extend to the edges of the glass core 620. As shown in Figure 6A, a trench 631 is provided proximate to an edge of the unit 600. The trench 631 may be a ring, such as a rectangular ring. The trench 631 may be used as a stress relief feature in order to prevent or limit the transfer of stress from the buildup layers 640 into the glass core 620. The trench 631 passes through an entire thickness of the buildup layers 640 in order to expose a surface of the glass core 620.

In an embodiment, a liner 637 is provided along an outer surface of the trench 631. The liner 637 may comprise a material that is different than the material of the buildup layers 640. More particularly, the liner 637 may have a different CTE than the CTE of the buildup layers 640. The difference in the CTE can be used in order to provide a controlled warpage of the unit 600. This controlled warpage can be used to apply a compressive force to the glass core 620, as will be described in greater detail below.

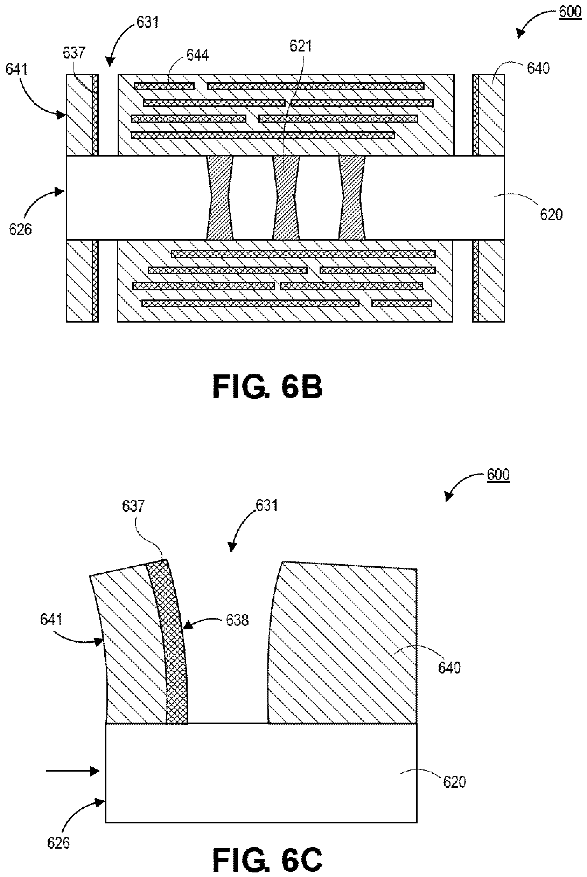

Referring now to Figure 6B, a cross-sectional illustration of the package substrate unit 600 in Figure 6A along line 6-6' is shown, in accordance with an embodiment. In an embodiment, the glass core 620 may comprise electrically conductive vias 621 that pass through a thickness of the glass core 620. The vias 621 may have any shape (e.g., tapered sidewalls, vertical sidewalls, etc.). In some instances, a liner (not shown) may be provided between the vias 621 and the glass core 620.

Buildup layers 640 may be provided above and below the glass core 620. The buildup layers 640 may extend to the edge of the glass core 620. That is, instead of having a setback, an edge 641 of the buildup layers 640 may be substantially coplanar with an edge 626 of the glass core 620. For example, a singulation process used to form the unit 600 may include passing a saw blade through the buildup layers 640 and the glass core 620. The buildup layers 640 may include electrically conductive features 644 (e.g., pads, traces, vias, etc.). The electrically conductive features 644 may be fabricated during the assembly of the buildup layers 640 using traditional packaging assembly processes.

In an embodiment, trenches 631 pass through the buildup layers 640 to expose portions of the top surface and bottom surface of the glass core 620. In an embodiment, the trenches 631 may be set in from an edge 626 of the glass core 620. For example, the outer wall of the trenches 631 may be up to 250µm from the edge 626 of the glass core 620. In some instances, the outer wall of the trenches 631 may be between and 100µm from the edge 626 of the glass core 620. The walls of the trenches 631 may be substantially vertical in some embodiments. That is, the walls of the trenches 631 may be substantially orthogonal to the top surface of the glass core 620.

In an embodiment, a liner 637 is provided along outer sidewalls of the trenches 631. The liner 637 may comprise a material different than the buildup layers 640. For example, the liner 637 may comprise a metallic material, such as copper or the like. The liner 637 may cover an entirety of the sidewall of the trench 631 in some embodiments. The liner 637 may have a thickness that is up to approximately 20% of the thickness of the trench 631. For example, the liner 637 may have a thickness that is up to approximately 25µm in some embodiments.

Referring now to Figure 6C, a zoomed in cross-sectional illustration of a portion of the unit 600 is shown, in accordance with an embodiment. As shown, the region of the buildup layers 640 outside of the trench 631 may have a controlled warpage. For example, the edge 641 of the buildup layers 640 may be curved or otherwise non-linear. Similarly, the surface 638 of the liner 637 may be curved away from the remainder of the buildup layers 640 on the opposite side of the trench 631. The curvature may be the result of a CTE mismatch between the liner 637 and the buildup layers 640. In an embodiment, the warpage may result in a compressive force (indicated by the arrow) being applied to the glass core 620. The compressive force may aid in reducing or eliminating the propagation of defects into the center of the glass core 620.

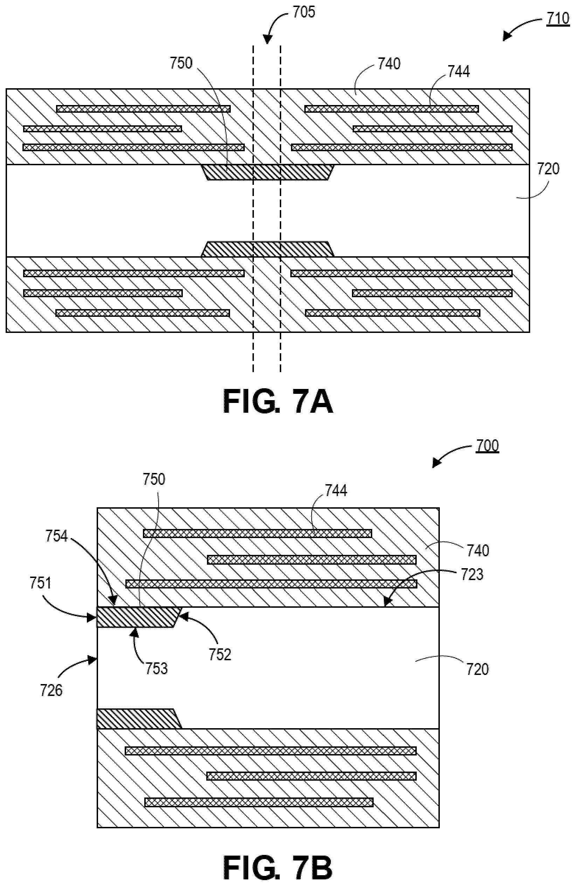

Referring now to Figure 7A, a cross-sectional illustration of a portion of a panel 710 is shown, in accordance with an embodiment. In an embodiment, the panel 710 may include a glass core 720 and buildup layers 740 above and/or below the glass core 720. Electrically conductive features 744 may be embedded in the buildup layers 740.

In an embodiment, an insert 750 may be at least partially embedded in the glass core 720. For example, a pair of inserts 750 are provided in the glass core 720, with one insert at the top surface of the glass core 720 and a second insert at the bottom of the glass core 720. In an embodiment, the inserts 750 may extend across a saw street 705 that is used to define individual units.

The inserts 750 may be a different material than the glass core 720. More particularly, the inserts 750 may be a material that has a similar CTE to the glass core 720, while also having a higher modulus than the glass core 720. For example, the CTE of the insert 750 may be within approximately 20% of the CTE of the glass core 720. The increased modulus of the insert 750 allows for excess stress induced into the glass core 720 to be absorbed by the insert 750. This prevents or minimizes the propagation of defects into the glass core 720.

Referring now to Figure 7B, a cross-sectional illustration of a portion of a package substrate unit 700 is shown, in accordance with an embodiment. The unit 700 in Figure 7B may be the result of a singulation process of the panel 710 along the saw street 705 in Figure 7A.

As shown, the insert 750 may have an outer edge 751 that is substantially coplanar with an edge 726 of the glass core 720. The top surface 754 of the insert 750 may be substantially coplanar with the top surface 723 of the glass core 720. The bottom surface 753 of the insert 750 may be substantially parallel to the top surface 723 of the glass core 720. In an embodiment, the inner edge 752 of the insert 750 may be sloped. The sloped profile of the inner edge 752 may further reduce stress transfer into the glass core 720. The insert 750 may extend into the glass core 720 any suitable distance. For example, a length of the insert 750 may be up to approximately 250µm. In other embodiments, the length of the insert 750 may be between approximately and approximately 100µm.

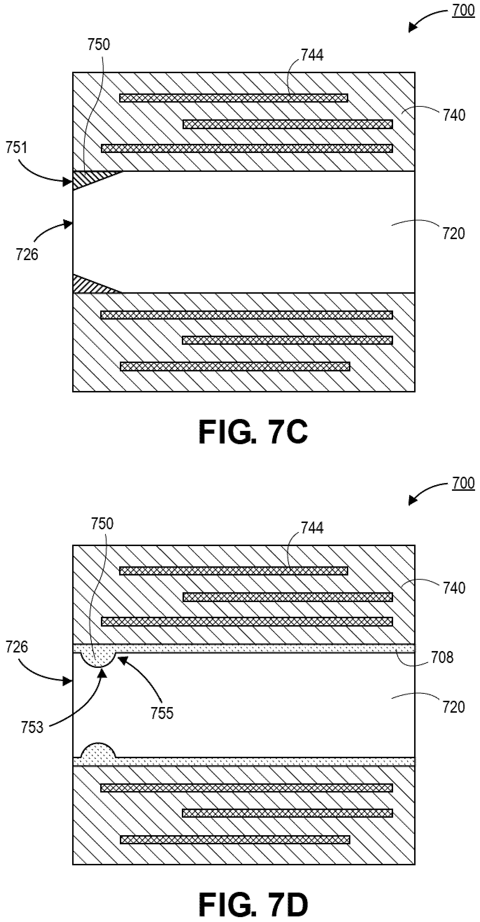

Referring now to Figure 7C, a cross-sectional illustration of a package substrate unit 700 is shown, in accordance with an additional embodiment. In an embodiment, the unit 700 in Figure 7C is similar to the unit 700 in Figure 7B, with the exception of the shape of the insert 750. In Figure 7C, the insert 750 may have a triangular shape. The triangular insert 750 may have an edge 751 that is substantially coplanar with an edge 726 of the glass core 720. While certain shapes for the inserts 750 are shown in Figure 7B and 7C, it is to be appreciated that the insert 750 may take any suitable shape.

Referring now to Figure 7D, a cross-sectional illustration of a package substrate unit 700 is shown, in accordance with an additional embodiment. In Figure 7D, the unit 700 includes a buffer layer 708 that is provided between the buildup layers 740 and the glass core 720. The buffer layer 708 may be a dielectric material, such as an organic dielectric. The buffer layer 708 may be a different material than the buildup layers 740. Though, in other embodiments, the buffer layer 708 and the buildup layers 740 may comprise similar or the same material.

In an embodiment, a recess 753 may be provided into the top and/or bottom surface of the glass core 720. The recess 753 may be set into the glass core 720 away from the edge 726. In an embodiment, the recess 753 may be filled by an insert 750 that is part of the buffer layer 708. The recess 753 may have any suitable shape. In the illustrated embodiment, the recess 753 is a semi-circular recess into the surface of the glass core 720. Though, other shapes (e.g., rectangular, trapezoidal, triangular, etc.) may also be used in some embodiments. In the embodiment shown in Figure 7D, a corner 755 at the edge of the recess 753 is angular. However, stresses may be further reduced by rounding the corner 755 so that there are no sharp points that will concentrate stresses.

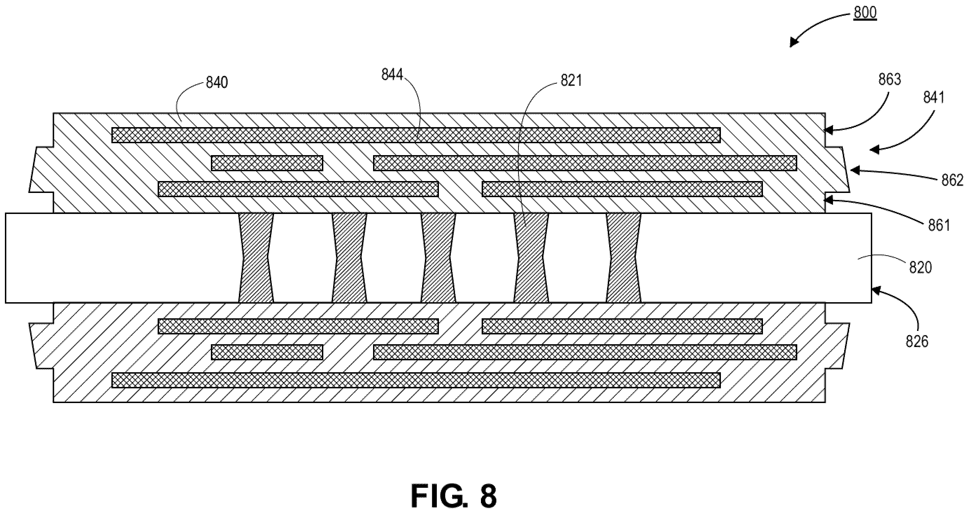

Referring now to Figure 8, a cross-sectional illustration of a package substrate unit 800 is shown, in accordance with an embodiment. In an embodiment, the unit 800 may comprise a glass core 820 with buildup layers 840 above and/or below the glass core 820. Vias 821 may be provided through a thickness of the glass core 820, and electrically conductive features 844 may be embedded in the buildup layers 840.

In an embodiment, an edge 841 of the buildup layers 840 may be set back from an edge 826 of the glass core 820. However, instead of having a planar edge 841, the edge 841 includes a plurality of sub-surfaces. For example, three sub-surfaces 861, 862, and 863 are provided in Figure 8. The first sub-surface 861 and the third sub-surface 863 may be substantially vertical (e.g., substantially orthogonal to the top surface of the glass core 820). In some embodiments, the first sub-surface 861 and the third sub-surface 863 may be provided on the same plane. In other embodiments, the first sub-surface 861 and the third sub-surface 863 may be on different planes. The second sub-surface 862 may be part of a protrusion that extends out beyond the first sub-surface 861 and the third sub-surface 863. The second sub-surface 862 may have a sloped profile in some embodiments.

The unique profile of the edge 841 of the buildup layers 840 is a result of the process used to clear the saw streets at the panel level. Instead of using a laser ablation process, dummy structures are fabricated and subsequently etched away. The dummy structures may include pads and vias arranged in a vertical stack through a thickness of the buildup layers 840. Removal with an etching process (e.g., a wet etching process) may allow for a decrease in the damage to the surface of the glass core 820, compared to a traditional laser ablation process.

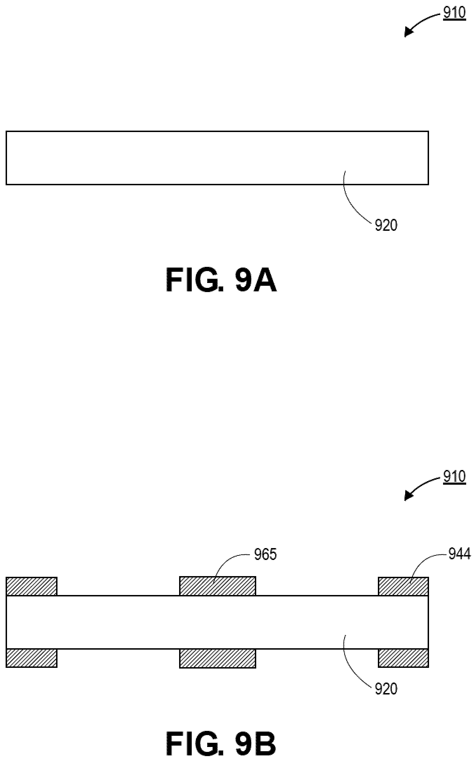

Referring now to Figures 9A - 9G a series of cross-sectional illustrations depicting a process for forming a package substrate unit with recessed buildup layer edges using a dummy structure process is shown, in accordance with an embodiment.

Referring now to Figure 9A, a cross-sectional illustration of a portion of a panel 910 is shown, in accordance with an embodiment. In an embodiment, the panel 910 may comprise a glass core 920.

Referring now to Figure 9B, a cross-sectional illustration of the portion of the panel 910 after first pads 965 are formed is shown, in accordance with an embodiment. In an embodiment, the first pads 965 may be formed in conjunction with other electrically conductive features 944 over the glass core 920. While referred to as a "pad", it is to be appreciated that the pads 965 may be elongated features. For example, the first pads 965 may extend along an entire saw street of the panel 910. The first pads 965 may be formed with any plating and patterning process typical of electronic packaging solutions.

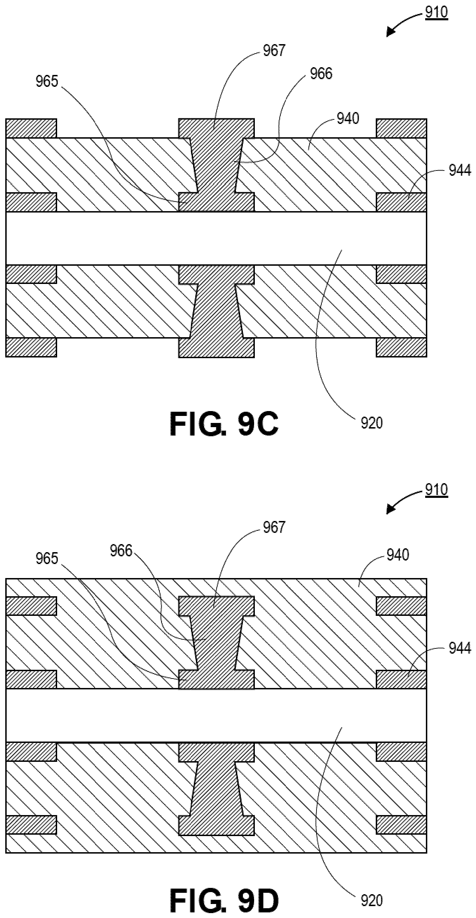

Referring now to Figure 9C, a cross-sectional illustration of the portion of the panel 910 after buildup layers 940 and additional metal layers 966 and 967 are formed is shown, in accordance with an embodiment. The metal layer 966 may be a via 966 that connects a second pad 967 to the first pad 965. The via 966 may have tapered sidewalls in some embodiments. The first pad 965 and the second pad 967 may have similar widths and thicknesses. Alternatively, the widths and/or the thicknesses of the first pad 965 and the second pad 967 may be different. The first pad 965 and the second pad 967 may be aligned with each other in some embodiments. For example, a centerline of the first pad 965 may be substantially coincident with a centerline of the second pad 967. Similar to the first pads 965, the vias 966 and the second pads 967 may be elongated structures that extend along a length of the saw street of the panel 910.

Referring now to Figure 9D, a cross-sectional illustration of the portion of the panel 910 after an additional portion of the buildup layers 940 is provided above the second pad 967 is shown, in accordance with an embodiment. The additional buildup material may be applied with a lamination process or the like.

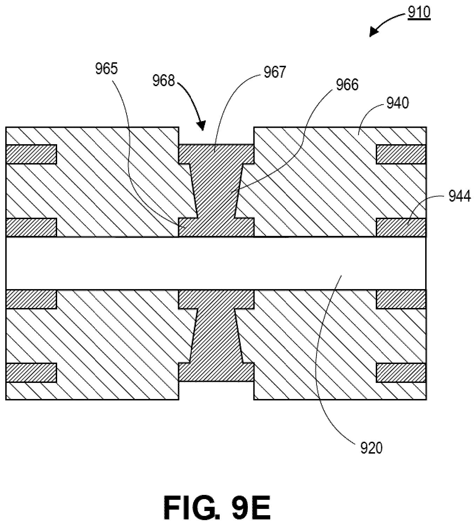

Referring now to Figure 9E, a cross-sectional illustration of the portion of the panel 910 after an opening 968 is formed to expose the second pad 967 is shown, in accordance with an embodiment. The opening 968 may be formed with an etching process or the like. The opening 968 in Figure 9E has an equal width to the second pad 967. Though, the opening 968 may also be narrower or wider than the second pad 967 in some embodiments.

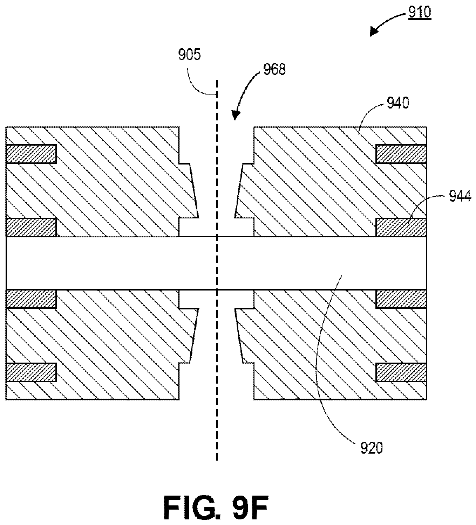

Referring now to Figure 9F, a cross-sectional illustration of the portion of the panel 910 after the first pads 965, the vias 966, and the second pads 967 are removed is shown, in accordance with an embodiment. The features 965, 966, and 967 may be removed with an etching process, such as a wet etching process. In an embodiment, the removal of the features 965, 966, and 967 results in the opening 968 extending down to the surfaces of the glass core 920. In an embodiment, a saw street 905 may be provided along the opening 968.

In Figures 9A - 9F it is to be appreciated that a single buildup layer 940 is provided over the top and bottom of the glass core 920. However, in some embodiments, the processing may be repeated any number of times in order to form multiple buildup layers 940. In such an instance the features 965, 966, and 967 may be repeated for each buildup layer 940, and after all of the buildup layers are formed the metal can all be etched at the same time.

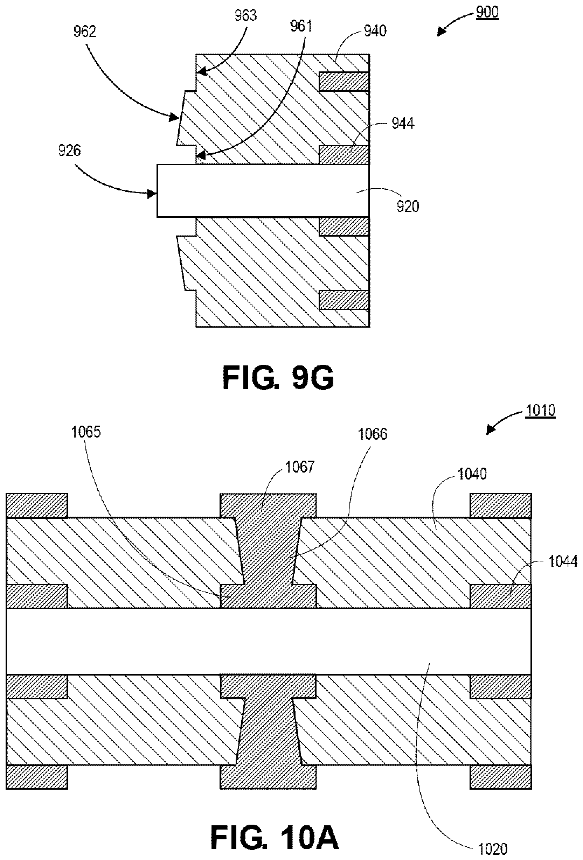

Referring now to Figure 9G, a cross-sectional illustration of a portion of a package substrate unit 900 after singulation is shown, in accordance with an embodiment. As shown, the edge of the buildup layers 940 are set back from the edge 926 of the glass core 920. Additionally, the edge of the buildup layers 940 may include multiple sub-surfaces. For example, a first sub-surface 961, a second sub-surface 962, and a third sub-surface 963 may be provided. The second sub-surface 962 may be part of a protrusion that extends past the first sub-surface 961 and the third sub-surface 963. That is, the protrusion may be between a top surface and a bottom surface of the buildup layers 940. In an embodiment, the second sub-surface 962 may include a sloped profile.

Referring now to Figures 10A - 10C, a series of cross-sectional illustrations depicting a process for forming a package substrate unit is shown, in accordance with an additional embodiment.

Referring now to Figure 10A, a cross-sectional illustration of a portion of a panel 1010 is shown, in accordance with an embodiment. The panel 1010 may include a glass core 1020 with buildup layers 1040 above and/or below the glass core 1020. In an embodiment, electrically conductive features 1044 may be provided in the buildup layers 1040. Additionally, dummy features may be provided through a thickness of the buildup layers 1040. For example, the dummy features may include copper or other metallic structures, such as a first pad 1065, a via 1066, and a second pad 1067.

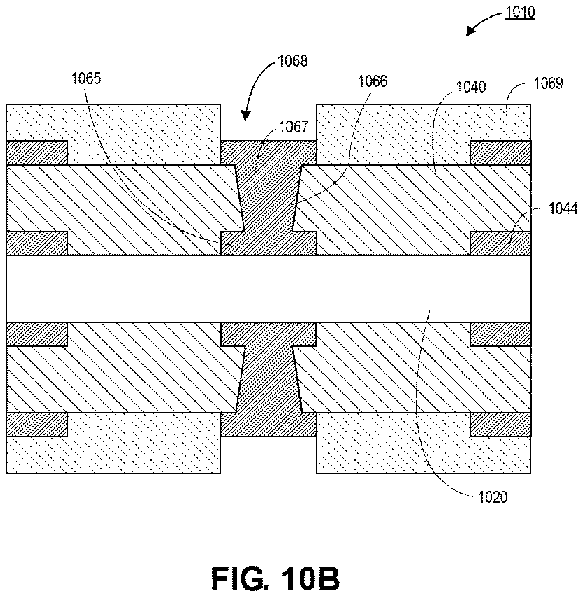

Referring now to Figure 10B, a cross-sectional illustration of the portion of the panel 1010 after resist layers 1069 are applied over the buildup layers 1040 is shown, in accordance with an embodiment. In an embodiment, the resist layers 1069 may include an opening 1068 that exposes the dummy features. Particularly, the opening 1068 may be aligned with the second pad 1067.

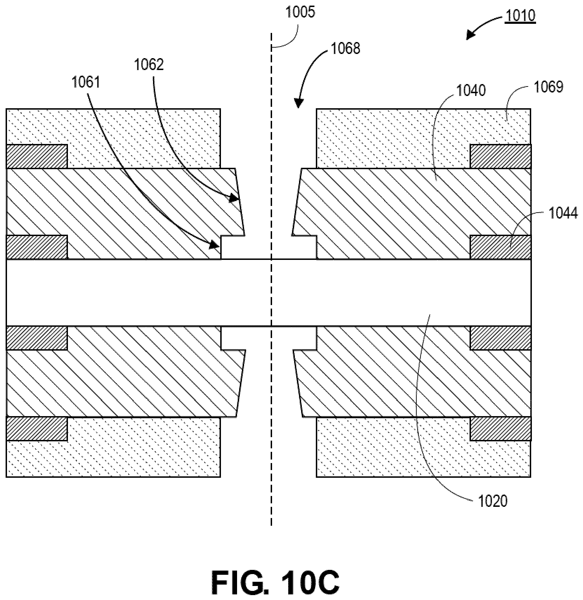

Referring now to Figure 10C, a cross-sectional illustration of the portion of the panel 1010 after the dummy features 1065, 1066, and 1067 are removed is shown, in accordance with an embodiment. The dummy features 1065, 1066, and 1067 may be removed with an etching process, such as a wet etching process. The etching results in the opening 1068 extending down to the glass core 1020. The opening 1068 results in the formation of a multi-surface edge to the buildup layers 1040. For example, a first sub-surface 1061 and a second sub-surface 1062 are provided. The second sub-surface 1062 may have a sloped profile. Additionally, the second sub-surface 1062 may be part of a protrusion that is at a top of the buildup layers 1040.

In Figures 10A - 10C it is to be appreciated that a single buildup layer 1040 is provided over the top and bottom of the glass core 1020. However, in some embodiments, the processing may be repeated any number of times in order to form multiple buildup layers 940. In such an instance the dummy features 1065, 1066, and 1067 may be repeated for each buildup layer 1040, and after all of the buildup layers are formed the metal can all be etched at the same time.

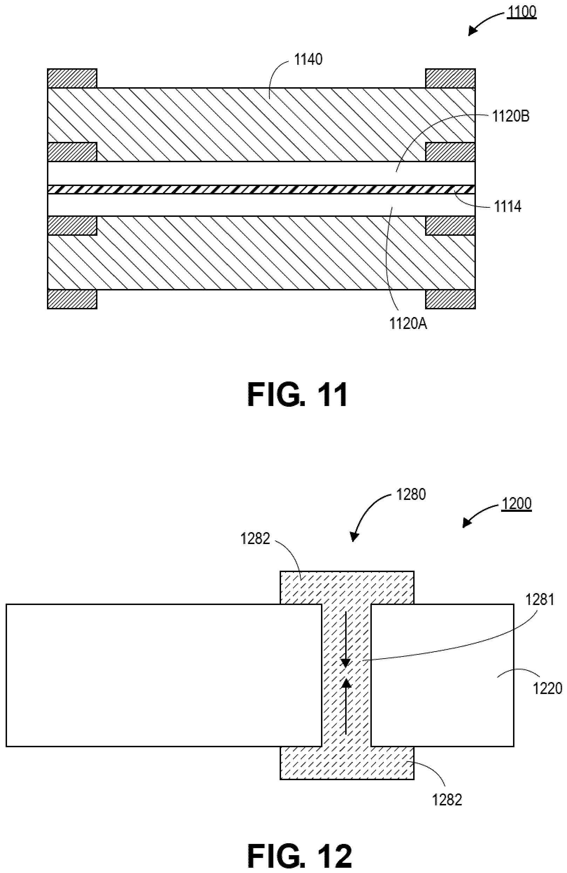

Referring now to Figure 11, a cross-sectional illustration of a package substrate unit 1100 is shown, in accordance with an embodiment. In an embodiment, the unit 1100 may comprise a composite core. For example, a first glass layer 1120A and a second glass layer 1120B may be separated from each other by an interface layer 1114. The interface layer 1114 may be a dielectric material, such as an organic dielectric or the like. The interface layer 1114 may absorb stress applied to the glass layers 1120A and 1120B that results from the CTE mismatch between the buildup layers 1140 and the glass layers 1120A and 1120B.

Referring now to Figure 12, a cross-sectional illustration of a portion of a package substrate unit 1200 is shown, in accordance with an embodiment. In an embodiment, the unit 1200 comprises a glass core 1220. In an embodiment, a pin 1280 is provided through a thickness of the glass core 1220. The pin 1280 may comprise a via 1281 that connects pads 1282 on opposite surfaces of the glass core 1220. In an embodiment, the pin 1280 is cured, and the curing process results in shrinking of the material of the pin 1280. Accordingly, as indicated by the arrows in the via 1281, the pads 1282 are pulled together. This induces a compressive force on the glass core 1220, and the compressive force can limit or prevent the propagation of defects within the glass core 1220. In an embodiment, the material of the pin 1280 may be a high CTE organic material. In a particular embodiment, the pin 1280 may be a buildup film material with (or without) inorganic filler particles.

In other embodiments, the compressive force may be due to one or both of the shrinkage of the material of the pin 1280 during curing (or during deposition and/or processing of any other layer), and residual stress of the material. For example, the residual stresses may be generated because of thermal expansion/contraction of the material of the pin 1280. The residual stresses in the glass core 1220 will be compressive if the CTE of the pin 1280 is higher than the CTE of the glass core, and the package substrate unit 1200 is processed at elevated temperatures (e.g., room temperature or operating temperatures that range, for example, between approximately -55°C and approximately 125°C).

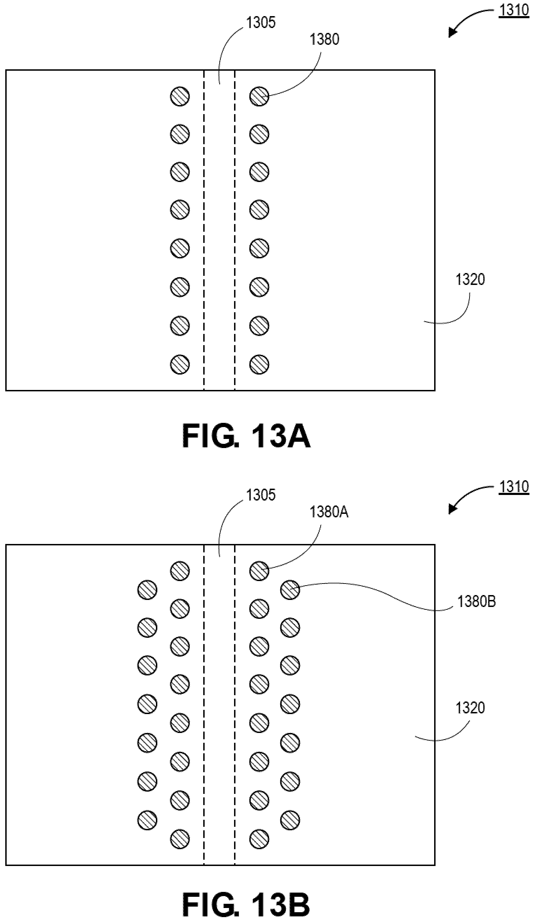

Referring now to Figures 13A - 13C a series of plan view illustrations of portions of a panel 1310 with an array of compressive pins is shown, in accordance with various embodiments.

Referring now to Figure 13A, a plan view illustration of a portion of a panel 1310 is shown, in accordance with an embodiment. In an embodiment, the panel 1310 includes a saw street 1305. The saw street 1305 may separate individual units within the panel 1310. In an embodiment, a column of pins 1380 may be provided along each side of the saw street 1305. The pins 1380 may be similar to the pin 1280 described in greater detail above with respect to Figure 12. In the illustrated embodiment, the pins 1380 have a circular shape. Though, square shapes, rectangular shapes, or any other shape may also be used for the pins 1380 in some embodiments. The pins 1380 may be up to approximately 250µm away from the edge of the saw street 1305 (or from the edge of an individual unit of the glass core 1320). The pins 1380 may have a diameter that is between approximately 1µm and approximately 90µm.

Referring now to Figure 13B, a plan view illustration of a portion of a panel 1310 is shown, in accordance with an additional embodiment. The panel 1310 may be similar to the panel 1310 in Figure 13A, with the exception of there being more than one column of pins 1380 on each side of the saw street 1305. For example, a first column of pins 1380A and a second column of pins 1380B may be provided through the glass core 1320. The first column of pins 1380A may be offset from the second column of pins 1380B. In other embodiments, the pins 1380A may be aligned with the pins 1380B.

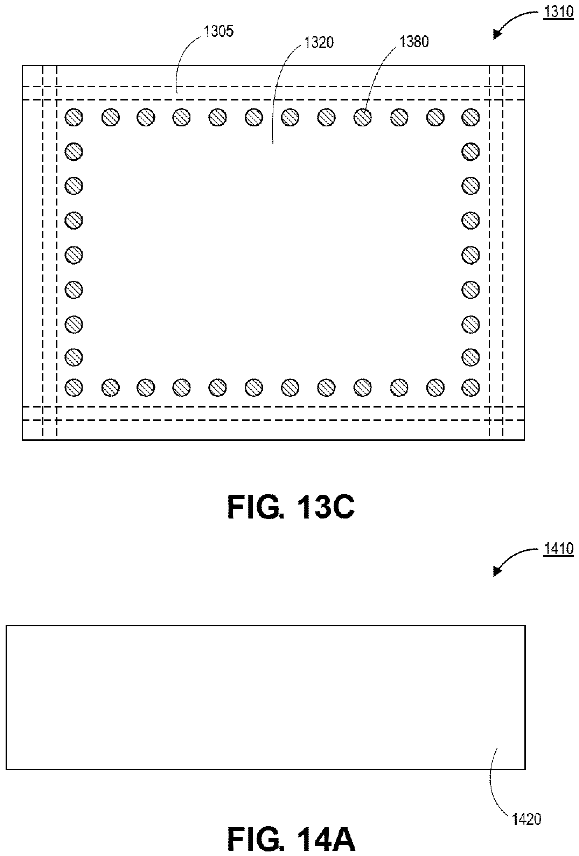

Referring now to Figure 13C, a plan view illustration of a portion of a panel 1310 is shown, in accordance with an additional embodiment. The glass core 1320 in Figure 13C is shown as being surrounded by saw streets 1305 on all four sides in order to define an individual unit within the panel 1310. As shown, pins 1380 may be positioned in a ring around a perimeter of the unit. While a single ring is shown, two or more rings of pins 1380 may be used in other embodiments.

Referring now to Figures 14A - 14G, a series of cross-sectional illustrations depicting a process for forming pins 1480 through a glass core 1420 is shown, in accordance with an embodiment. As shown, the openings for the pins 1480 may be formed at the same time as openings for electrically conductive vias. The shape and size of the pin openings and the via openings may also be similar to each other in some instances.

Referring now to Figure 14A, a cross-sectional illustration of a portion of a panel 1410 is shown, in accordance with an embodiment. In an embodiment, the panel 1410 may comprise a glass core 1420, similar to any of the glass cores described in greater detail herein.

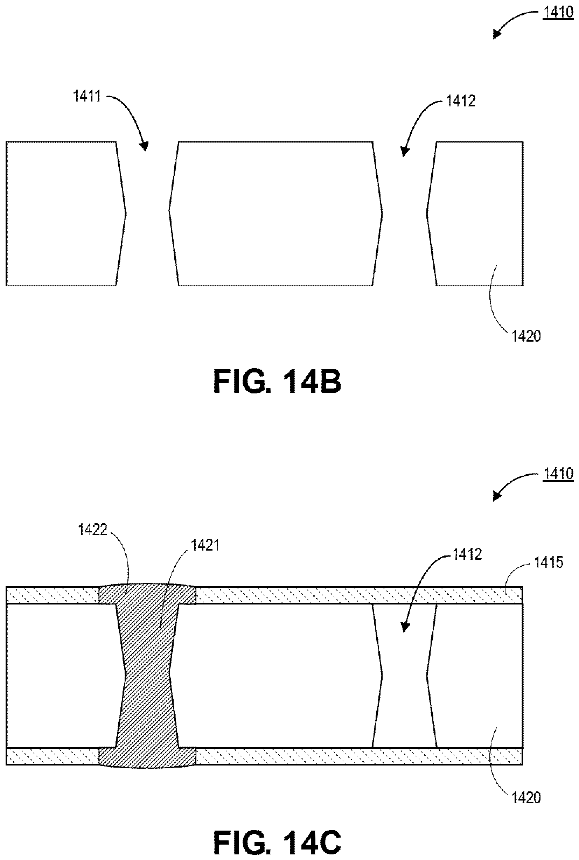

Referring now to Figure 14B, a cross-sectional illustration of the portion of the panel 1410 after openings 1411 and 1412 are formed is shown, in accordance with an embodiment. The opening 1411 may be a via opening through a thickness of the glass core 1420. Similarly, the pin opening 1412 may pass through the thickness of the glass core 1420. The openings 1411 and 1412 may be formed with any suitable process. For example, a laser assisted etching process may be used in order to form the openings 1411 and 1412. In such an embodiment, sidewalls of the openings 1411 and 1412 may be tapered. For example, openings 1411 and 1412 have hourglass shaped cross-sections. In other embodiments, the openings 1411 and 1412 may have substantially vertical sidewalls. As shown in Figure 14B, the dimensions and shape of the openings 1411 and 1412 may be similar or the same as each other. Though, opening 1411 may be different from opening 1412 in other embodiments.

Referring now to Figure 14C, a cross-sectional illustration of the portion of the panel 1410 after a via 1421 is formed in the via opening 1411 is shown, in accordance with an embodiment. The via 1421 may be formed with an electroplating process or the like. A resist layer 1415 may be used to cover the pin opening 1412 during the plating process. The resist layer 1415 may have an opening wider than the via 1421 in order to define pads 1422 above and below the via 1421 in some embodiments.

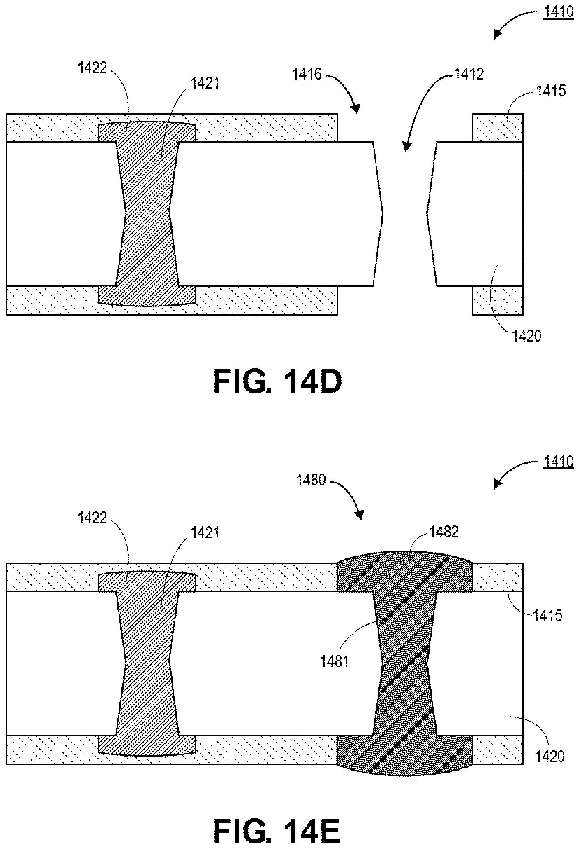

Referring now to Figure 14D, a cross-sectional illustration of the portion of the panel 1410 after a second resist layer 1415 is patterned to expose the pin opening 1412 is shown, in accordance with an embodiment. In an embodiment, the resist layer 1415 may have an opening 1416 that exposes the pin opening 1412. The opening 1416 may have a width wider than the pin opening 1412 in order to allow for the formation of the pads above and below the pin.

Referring now to Figure 14E, a cross-sectional illustration of the portion of the panel 1410 after a pin 1480 is formed through the glass core 1420 is shown, in accordance with an embodiment. In an embodiment, the pin 1480 may comprise via 1481 with pads 1482 above and below the via 1481. The material of the pin 1480 is different than the material of the via 1421. For example, the pin 1480 may comprise an organic dielectric material, such as a buildup film, an epoxy, a mold material, or the like. Pin 1480 may include filler particles, such as inorganic filler particles. In an embodiment, the pin 1480 may be in an uncured state in Figure 14E. In an embodiment, the pin 1480 may be deposited with any suitable process, such as, but not limited to, slit coating, ink j etting, or the like.

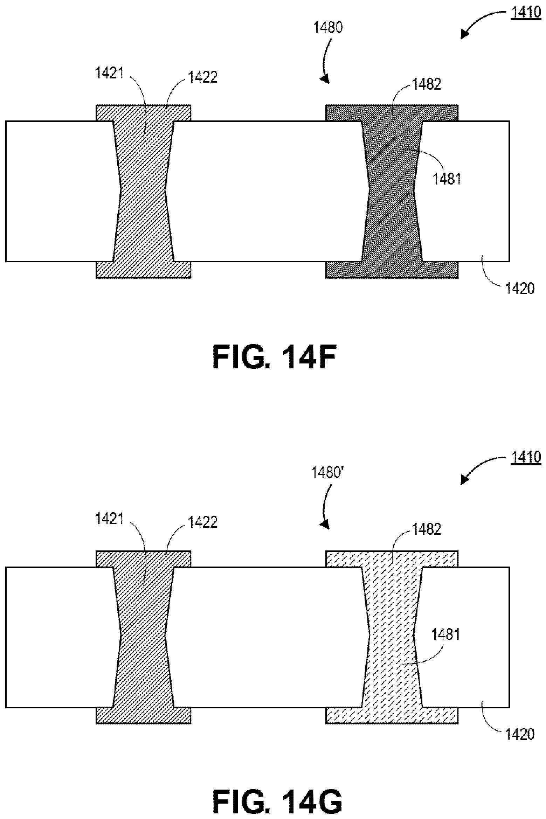

Referring now to Figure 14F, a cross-sectional illustration of the portion of the panel 1410 after a polishing operation is shown, in accordance with an embodiment. In an embodiment, the resist layer 1415 is removed, and a polishing process is implemented. For example, a chemical mechanical polishing (CMP) process or other planarization process may be used in order to provide a substantially coplanar relationship between the top surface of the pad 1422 and a top surface of the pad 1482.

Referring now to Figure 14G, a cross-sectional illustration of the portion of the panel 1410 after a curing process is shown, in accordance with an embodiment. The curing process results in the pin 1480' having shrinkage. The shrinkage throughout the pin 1480' may result in the pads 1482 above and below the via 1481 being pulled towards each other. This force applies a compressive force on the glass core 1420. This can result in a reduction or elimination of defect propagation through the glass core 1420.

In some of the embodiments described herein, reference is made to panel level products or unit level products. It is to be appreciated that unit level products can be fabricated from panel level products (e.g., through singulation processes). Though, unit level products can also be formed independently without being formed initially in a panel structure.

Further, embodiments disclosed herein are not limited to just the package substrate unit. The package substrate unit can be part of a larger system. In such an embodiment, a board (e.g., a printed circuit board (PCB)) may be mounted to one side of the unit. For example, second level interconnects (SLIs), such as solder balls or pins, can mechanically and electrically couple the package substrate unit to the board. Additionally, first level interconnects (FLIs) on the opposite side of the package substrate unit may mechanically and electrically couple the unit to one or more dies. The dies may include compute dies, such as central processing units (CPUs), graphics processing units (GPUs), XPUs, communications dies, memory dies, or the like. In some instances, two or more dies may be communicatively coupled together through a bridge die that is embedded in the buildup layers or provided over the buildup layers. In some instances, an interposer may also be provided between any of the board, package substrate unit, and the dies.

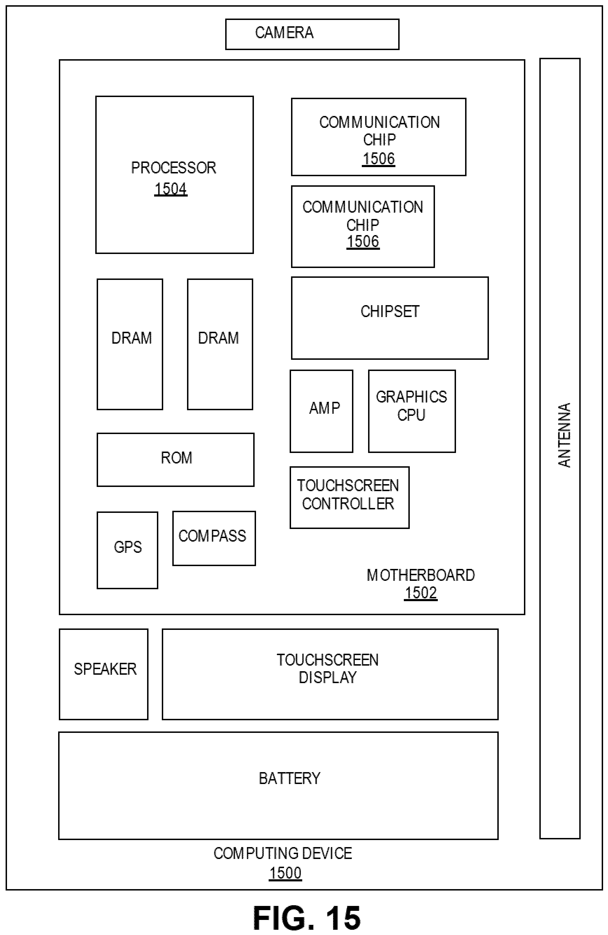

Figure 15 illustrates a computing device 1500 in accordance with one implementation of the disclosure. The computing device 1500 houses a board 1502. The board 1502 may include a number of components, including but not limited to a processor 1504 and at least one communication chip 1506. The processor 1504 is physically and electrically coupled to the board 1502. In some implementations the at least one communication chip 1506 is also physically and electrically coupled to the board 1502. In further implementations, the communication chip 1506 is part of the processor 1504.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1506 enables wireless communications for the transfer of data to and from the computing device 1500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1506 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1500 may include a plurality of communication chips 1506. For instance, a first communication chip 1506 may be dedicated to shorter range wireless communications such as Wi-Fi and Bluetooth and a second communication chip 1506 may be dedicated to longer range wireless communications such as GPS, EDGE, GPRS, CDMA, WiMAX, LTE, Ev-DO, and others.

The processor 1504 of the computing device 1500 includes an integrated circuit die packaged within the processor 1504. In some implementations of the disclosure, the integrated circuit die of the processor may be part of an electronic package that includes a package substrate with a glass core that includes one or more stress reduction features in order to mitigate stresses resulting from a CTE mismatch between the glass core and overlying buildup layers, in accordance with embodiments described herein. The term "processor" may refer to any device or portion of a device that processes electronic data from registers and/or memory to transform that electronic data into other electronic data that may be stored in registers and/or memory.

The communication chip 1506 also includes an integrated circuit die packaged within the communication chip 1506. In accordance with another implementation of the disclosure, the integrated circuit die of the communication chip may be part of an electronic package that includes a package substrate with a glass core that includes one or more stress reduction features in order to mitigate stresses resulting from a CTE mismatch between the glass core and overlying buildup layers, in accordance with embodiments described herein.

In an embodiment, the computing device 1500 may be part of any apparatus. For example, the computing device may be part of a personal computer, a server, a mobile device, a tablet, an automobile, or the like. That is, the computing device 1500 is not limited to being used for any particular type of system, and the computing device 1500 may be included in any apparatus that may benefit from computing functionality.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: an apparatus, comprising: a core with a first width, wherein the core comprises a glass layer; a via through a thickness of the core, wherein the via is electrically conductive; a first layer over the core, wherein the first layer comprises a second width that is smaller than the first width; and a second layer under the core, wherein second layer comprises a third width that is smaller than the first width.

Example 2: an apparatus of Example 1, wherein an edge surface of the first layer is set back from an edge surface of the core by up to approximately 250µm.

Example 3: the apparatus of Example 1 or Example 2, wherein an edge surface of the first layer is along a first plane and an edge surface of the core is along a second plane, wherein the first plane intersects the second plane.

Example 4: the apparatus of Example 3, wherein a top surface of the first layer is narrower than a bottom surface of the first layer.

Example 5: the apparatus of Examples 1-4, further comprising: a trench through a thickness of the first layer, wherein an island of the first layer is provided between an edge surface of the first layer and the trench.

Example 6: the apparatus of Example 5, wherein a width of the island of the first layer is up to approximately 200µm.

Example 7: the apparatus of Examples 1-6, wherein an outer edge surface of the first layer comprises a protrusion between a top surface and a bottom surface of the first layer.

Example 8: the apparatus of Examples 1-7, wherein the core has an outer region and an inner region, wherein the outer region has a first defect density and the inner region has a second defect density that is lower than the first defect density.

Example 9: the apparatus of Example 8, wherein the outer region has a width from an edge of the core to an outer edge surface of the inner region that is up to approximately 200µm.

Example 10: the apparatus of Examples 1-9, wherein the first layer and the second layer comprise organic buildup layers.

Example 11: an apparatus, comprising: a core, wherein the core comprises glass; and a layer over the core, wherein the layer comprises an organic buildup film; and a trench through a thickness of the layer, wherein the trench is a ring set in a distance from outer edge surfaces of the layer.

Example 12: the apparatus of Example 11, further comprising: a liner along an outer sidewall of the trench.

Example 13: the apparatus of Example 12, wherein the liner comprises copper.

Example 14: the apparatus of Examples 11-13, wherein an outer edge surface of the layer is substantially coplanar with an outer edge surface of the core.

Example 15: the apparatus of Examples 11-14, wherein the trench has sidewalls with sloped profiles.

Example 16: an apparatus, comprising: a core, wherein the core comprises a glass layer; a layer over the core; and an insert at least partially embedded in the core, wherein the insert comprises a material different than the glass layer.

Example 17: the apparatus of Example 16, wherein the insert has a coefficient of thermal expansion (CTE) that is within 20% of a CTE of the core, and wherein a modulus of the insert is greater than a modulus of the core.

Example 18: the apparatus of Example 16 or Example 17, wherein the insert is an organic dielectric material that fills a recess into a surface of the core.

Example 19: the apparatus of Examples 16-18, wherein the insert passes through a thickness of the core, and wherein a first pad is over the insert and a second pad is under the insert.

Example 20: the apparatus of Example 19, comprises a cured buildup film.

Example 21: an apparatus, comprising: a core, wherein the core comprises a glass layer; a layer over the core, wherein the layer comprises an organic buildup film; and a trench through a thickness of the layer, wherein the trench defines an outer portion of the layer and an inner portion of the layer, and wherein the inner portion comprises one or more routing features that are electrically conductive and the outer portion is free from routing features.

Example 22: the apparatus of Example 21, wherein the trench has sidewalls that are substantially orthogonal to a top surface of the layer.

Example 23: the apparatus of Example 21 or Example 22, wherein the trench has sidewalls with a sloped profile.

Example 24: the apparatus of Examples 21-23, wherein the trench is a ring surrounding an entirety of the inner portion.

Example 25: the apparatus of Examples 21-24, wherein a width of the trench is up to approximately 250µm.

Example 26: the apparatus of Examples 21-25, further comprising: a liner along an outer sidewall of the trench.

Example 27: the apparatus of Example 26, wherein the liner comprises copper.

Example 28: the apparatus of Example 26 or Example 27, wherein the liner and the outer portion bend away from the inner portion.

Example 29: the apparatus of Examples 21-28, wherein the outer portion has a width up to approximately 250µm.

Example 30: the apparatus of Examples 21-29, wherein the core has a thickness up to 2,000µm.

Example 31: an apparatus, comprising: a core, wherein the core comprises a glass layer; a layer over the core, wherein the layer is an organic buildup film; and an insert that extends into a surface of the core, wherein a material composition of the insert is different than a material composition of the core.

Example 32: the apparatus of Example 31, wherein the insert has a first coefficient of thermal expansion (CTE) and a first modulus, and wherein the core has a second CTE and a second modulus, wherein the first CTE is within 20% of the second CTE, and wherein the first modulus is higher than the second modulus.

Example 33: the apparatus of Example 31 or Example 32, wherein the insert has a top surface that is substantially coplanar with a top surface of the core and a second surface that is offset from the top surface of the core.

Example 34: the apparatus of Example 33, wherein a first sidewall of the insert is substantially coplanar with a sidewall of the core, and wherein a second sidewall of the insert is sloped.

Example 35: the apparatus of Examples 31-34, wherein the insert is triangular with a sidewall that is substantially coplanar with a sidewall of the core.

Example 36: the apparatus of Examples 31-35, wherein the insert fills a trench into a top surface of the core.

Example 37: the apparatus of Example 36, wherein the trench has a rounded bottom surface.

Example 38: the apparatus of Example 37, wherein a corner between the trench and a top surface of the core is rounded.

Example 39: the apparatus of Examples 31-38, wherein the insert comprises a buildup film material with inorganic filler particles.

Example 40: the apparatus of Examples 31-39, further comprising: a second insert on an opposite surface of the core from the insert.

Example 41: an apparatus, comprising: a core, wherein the core comprises a glass layer; and a layer over the core, wherein the layer comprises an organic buildup film, and wherein a protrusion extends out from a sidewall of the layer.

Example 42: the apparatus of Example 41, wherein the protrusion has a sloped edge profile.

Example 43: the apparatus of Example 42, wherein a length of a top surface of the protrusion is smaller than a length of a bottom surface of the protrusion.

Example 44: the apparatus of Examples 41-43, wherein the protrusion is between a top surface of the layer and a bottom surface of the layer.

Example 45: the apparatus of Examples 41-44, wherein the protrusion is at a top of the layer.

Example 46: the apparatus of Examples 41-45, wherein an edge of the protrusion is set back from an edge of the core.

Example 47: the apparatus of Examples 41-46, wherein at least a portion of a top surface of the core is not covered by the layer.

Example 48: the apparatus of Example 47, wherein the portion of the top surface of the core is a ring around a perimeter of the core.

Example 49: the apparatus of Examples 41-48, wherein a first sidewall of the layer below the protrusion is substantially coplanar with a second sidewall of the layer above the protrusion.

Example 50: the apparatus of Example 49, wherein the first sidewall of the layer is shorter than the second sidewall of the layer.

Example 51: an apparatus, comprising: a core, wherein the core comprises a glass layer; a pin through a thickness of the core; a first pad over the pin; and a second pad under the pin, wherein the first pad and the second pad are wider than the pin.

Example 52: the apparatus of Example 51, wherein the pin is positioned within approximately 250µm of an edge of the core.

Example 53: the apparatus of Example 51 or Example 52, wherein the pin is circular when viewed in a plan view from above the core.

Example 54: the apparatus of Examples 51-53, wherein the pin has an hourglass shaped cross-section.

Example 55: the apparatus of Example 54, further comprising: a via through the thickness of the core, wherein the via is electrically conductive, and wherein a shape of the via is substantially similar to a shape of the pin.

Example 56: the apparatus of Examples 51-55, further comprising: a plurality of pins through the thickness of the core, wherein the plurality of pins are positioned in a ring proximate to an outer edge of the core.

Example 57: the apparatus of Examples 51-56, further comprising: a plurality of pins through the thickness of the core, wherein the plurality of pins are positioned in a first column and a second column proximate to an outer edge of the core.

Example 58: the apparatus of Examples 51-57, wherein the pin, the first pad, and the second pad are a monolithic structure.

Example 59: the apparatus of Examples 51-58, wherein the pin, the first pad, and the second pad comprise a cured buildup film.

Example 60: the apparatus of Example 59, wherein the pin, the first pad and the second pad apply a compressive force on the core.

## Claims

1. An apparatus, comprising:
a core with a first width, wherein the core comprises a glass layer;
a via through a thickness of the core, wherein the via is electrically conductive;
a first layer over the core, wherein the first layer comprises a second width that is smaller than the first width; and
a second layer under the core, wherein second layer comprises a third width that is smaller than the first width.

2. The apparatus of claim 1, wherein an edge surface of the first layer is set back from an edge surface of the core by up to approximately 250µm.

3. The apparatus of claim 1 or 2, wherein an edge surface of the first layer is along a first plane and an edge surface of the core is along a second plane, wherein the first plane intersects the second plane.

4. The apparatus of claim 3, wherein a top surface of the first layer is narrower than a bottom surface of the first layer.

5. The apparatus of claim 1, 2, 3 or 4, further comprising:
a trench through a thickness of the first layer, wherein an island of the first layer is provided between an edge surface of the first layer and the trench.

6. The apparatus of claim 5, wherein a width of the island of the first layer is up to approximately 200µm.

7. The apparatus of claim 1, 2, 3, 4, 5 or 6, wherein an outer edge surface of the first layer comprises a protrusion between a top surface and a bottom surface of the first layer.

8. The apparatus of claim 1, 2, 3, 4, 5, 6 or 7, wherein the core has an outer region and an inner region, wherein the outer region has a first defect density and the inner region has a second defect density that is lower than the first defect density.

9. The apparatus of claim 8, wherein the outer region has a width from an edge of the core to an outer edge surface of the inner region that is up to approximately 200µm.

10. The apparatus of claim 1, 2, 3, 4, 5, 6, 7, 8 or 9, wherein the first layer and the second layer comprise organic buildup layers.

11. A method, comprising:
providing a core with a first width, wherein the core comprises a glass layer;
forming a via through a thickness of the core, wherein the via is electrically conductive;
forming a first layer over the core, wherein the first layer comprises a second width that is smaller than the first width; and
forming a second layer under the core, wherein second layer comprises a third width that is smaller than the first width.

12. The method of claim 11, wherein an edge surface of the first layer is set back from an edge surface of the core by up to approximately 250µm.

13. The method of claim 11 or 12, wherein an edge surface of the first layer is along a first plane and an edge surface of the core is along a second plane, wherein the first plane intersects the second plane.

14. The method of claim 13, wherein a top surface of the first layer is narrower than a bottom surface of the first layer.

15. The method of claim 11. 12. 13 or 14, further comprising:
forming a trench through a thickness of the first layer, wherein an island of the first layer is provided between an edge surface of the first layer and the trench.
